# EUROPÄISCHE PATENTSCHRIFT

(11) **EP 0 989 611 B1**
(45) Veröffentlichungstag und Bekanntmachung des Hinweises auf die Patenterteilung: **08.12.2004**
(21) Anmeldenummer: 99810723.9
(22) Anmeldetag: 11.08.1999
(51) Int. Cl.: H01L 25/07, H01L 23/48

(54) **Kurzschlussfestes IGBT modul**
Short-circuit resistant IGBT module
Module de transistors bipolaires à grille isolée avec protection contre des courts-circuits

(30) Priorität: 22.09.1998 DE 19843309
(43) Veröffentlichungstag der Anmeldung: 29.03.2000
(73) Patentinhaber: ABB Schweiz AG, 5400 Baden (CH)
(72) Erfinder: Lang, Thomas Dr., 8051 Zürich (CH); Zeller, Hans-Rudolf, Dr., 5242 Birr (CH)
(74) Vertreter: ABB Patent Attorneys

(56) Entgegenhaltungen:
- EP-A- 0 702 406
- DE-A- 1 949 731
- DE-A- 2 257 078
- DE-A- 2 825 682
- US-A- 3 852 805

## Beschreibung

### TECHNISCHES GEBIET

Die vorliegende Erfindung bezieht sich auf das Gebiet der Leistungselektronik. Sie betrifft ein Hochleistungs-Halbleitermodul nach dem Oberbegriff des ersten Anspruchs, insbesondere ein IGBT (Insulated Gate Bipolar Transistor) Modul.

### STAND DER TECHNIK

Es hat sich gezeigt, dass beispielsweise bei druckkontaktierten Thyristoren ein Defekt zu einem Kurzschluss führt. Bei grossen Chipflächen bleibt dieser Kurzschluss über lange Zeit stabil erhalten. Sind in einem Stapel aus seriegeschalteten Thyristoren redundante Thyristoren vorgesehen, so können die restlichen, intakten Thyristoren während der Sperrphase die Spannung aufnehmen und der Stapel bleibt operativ. Defekte Thyristoren können in der Folge anlässlich von geplanten Servicearbeiten ausgetauscht werden.

In einem Thyristor Modul befindet sich der Halbleiter, d.h. das Si, in mechanischem und elektrischem Kontakt zwischen zwei Mo Scheiben. Si hat einen Schmelzpunkt von 1420°C, derjenige von Mo liegt höher und die intermetallischen Verbindungen aus Si und Mo haben einen noch höheren Schmelzpunkt. Im Defektfall schmilzt daher als erstes das Si *lokal* auf und es bildet sich unter Stromfluss ein leitender Kanal aus geschmolzenem Si über die ganze Dicke des Halbleiters. Diese Defektzone kann sich ausbreiten und/oder verschieben, wird aber stets nur einen kleinen Teil der Chipfläche betreffen. In hermetisch abgeschlossenen Gehäusen oxidiert das geschmolzene Si nicht, sondern reagiert mit Mo zu einer Art Pulver. Dieser Prozess dauert an bis alles Si aufgebraucht ist und kann sich möglicherweise über Jahre erstrecken.

Im Gegensatz zu den Thyristor Halbleiterbauelementen werden IGBT Chips nicht als grossflächige Einheiten produziert und in den IGBT Modulen sind normalerweise mehrere kleinflächige Einzelchips getrennt nebeneinander angeordnet. Ein derartiges Modul ist z.B. aus der EP 0 499 707 B1 bekannt. Dabei sind kleinflächige Einzelchips als Chips mit einer Fläche kleiner als 1cm² definiert. Auch EP 702406 A2 befasst sich mit druckkontaktierten Halbleitermodulen, die eine Vielzahl von Einzelchips, insbesondere IGBTs aufweisen.

Es hat sich nun gezeigt, dass für druckkontaktierte IGBT Module keine stabilen Kurzschlüsse der oben geschilderten Art erwartet werden können. Dies in erster Linie wegen der reduzierten Fläche der Einzelchips bzw. des geringen Siliziumvolumens. Die pseudostabile Phase eines Kurzschlusses dauert in diesem Fall nur wenige Stunden. Zudem sind die Gehäuse oftmals bewusst nicht hermetisch abgeschlossen, so dass das geschmolzene Silizium mit Sauerstoff reagieren und isolierendes Si0₂ bilden kann. Ohne stabilen Kurzschlusspfad im defekten Chip kann im schlimmsten Schadensfall folgendes passieren. Sind die restlichen Chips eines Moduls inklusive Ansteuerung noch intakt, können sie während der Sperrphase Spannung aufnehmen. Der Strom wird dann durch den defekten Chip gezwungen und kann in diesem bei Spannungen bis zur Durchbruchsspannung der intakten Chips zu einem Plasma mit sehr hoher Leistungsdichte führen. Als Folge davon wird das ganze Modul zerstört.

### DARSTELLUNG DER ERFINDUNG

Aufgabe der vorliegenden Erfindung ist es also, ein aus kleinflächigen Einzelchips aufgebautes Leistungshalbleitermodul zu schaffen, bei welchem ein Kurzschluss eines Einzelchips nicht zu einem Totalausfall des Moduls führt. Die Aufgabe wird bei einem Bauelement der oben genannten Art durch die Merkmale des ersten Anspruchs gelöst.

Der Kern der Erfindung besteht darin, dass eine Schicht aus einem geeigneten Material, beispielsweise Ag, in unmittelbaren Kontakt zu einer oder beiden Hauptelektroden des Si-Halbleiters gebracht wird. Das Material dieser Schicht muss mit Si ein Eutektikum bilden. Im Kurzschlussfall erwärmen sich die ganze Sandwichstruktur, und an der Kontaktfläche zwischen besagter Schicht und dem Si beginnt sich ab Erreichen des Schmelzpunktes des Eutektikums eine leitende Schmelze auszubilden. Diese Zone kann sich anschliessend über die Ganze Dicke des Halbleiters ausdehnen und somit einen metallisch leitenden Kanal formen.

Erfindungsgemäss wird im Schadensfall ein *stabiler* Kurzschluss ermöglicht, indem sich ein metallisch leitender Kanal zwischen den Hauptelektroden des betroffenen Si-Halbleiterchips ausbildet. Dieser Kanal ist auf einen Teil der Chipfläche begrenzt, übernimmt jedoch den gesamten Nennstrom und verhindert so eine weitere Erwärmung des restlichen Si. Der Schmelzpunkt der metallisch leitenden Schmelze in diesem Kanal beziehungsweise der entsprechenden festen, siliziumund silberhaltigen Verbindung muss also notwendigerweise tiefer liegen als der Schmelzpunkt von reinem Si.

### KURZE BESCHREIBUNG DER ZEICHNUNG

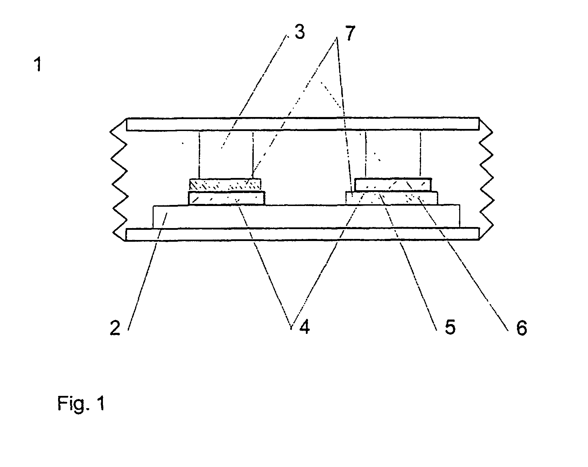

Fig.1 zeigt einen Querschnitt durch ein Leistungshalbleitermodul nach der Erfindung. Die Darstellung ist nicht massstabgetreu.

### WEGE ZU AUSFÜHRUNG DER ERFINDUNG

In Fig.1 ist im Querschnitt ein bevorzugtes Ausführungsbeispiel für ein Hochleistungs Halbleitermodul nach der Erfindung gezeigt. In einem gemeinsamen Gehäuse 1 sind eine Vielzahl von einzelnen Halbleiterchips 4 getrennt nebeneinander angeordnet, wobei in Fig. 1 nur zwei Einzelchips dargestellt sind. Diese Chips sind elektrisch parallelgeschaltet und die für hohe Ströme benötigte aktive Halbleiterfläche wird auf diese Weise aus einer Vielzahl von Einzelflächen zusammengesetzt. Nicht dargestellt sind in Fig.1 die normalerweise gebondeten Gateanschlüsse zur Ansteuerung des Halbleiterbauelementes.

Die Halbleiterchips 4 umfassen auf der Unter- und Oberseite je eine metallisierte Hauptelektrode 5,6, welche mit metallischen Kontaktflächen in elektrischem Kontakt stehen. Die Chips sind auf ein leitendes Substrat 2 aufgebracht und direkt über jedem Chip ist ein Kontaktstempel 3 angeordnet. Zwischen der ersten Hauptelektrode 5 und dem Substrat 2 einerseits und zwischen der zweiten Hauptelektrode 6 und dem Kontaktstempel 3 andererseits können weitere, in Fig. 1 nicht gezeigte Folien oder Scheiben vorgesehen sein, welche in ihrer thermischen Ausdehnung an das Silizium angepasst sind. Letztere sind beispielsweise aus Materialien wie Mo, Cu, oder Mo-Cu Kompositen gefertigt.

In einer ersten Ausführungsform wird ein ausreichender elektrischer Kontakt ausschliesslich über Druck erzeugt, welcher auf die Stirnflächen des Gehäuses 1 ausgeübt wird. Dabei drücken die Kontaktstempel 3 auf die zweite Hauptelektrode 6 und kontaktieren so den Chip 4. Diese Ausführungsform kommt also ohne Lot aus. Die erfindungsgemässe Schicht 7 kommt zwischen eine der Hauptelektroden 5,6 und die anschliessende metallische Kontaktfläche zu liegen. Es ist auch denkbar, anschliessend an beide Hauptelektroden je eine erfindungsgemässe Schicht 7 anzubringen. Die erfindungsgemässe Schicht 7 wird am einfachsten durch eine Folie aus dem entsprechenden Material realisiert oder auf die Hauptelektroden als Paste aufgetragen und enthält vorzugsweise Ag. Im Allgemeinen ist die Dicke der erfindungsgemässen Schicht 7 grösser als die halbe Dicke des Halbleiters 4 zu wählen. Dünne Metallisierungsschichten genügen nicht für die durchgehende Ausbildung eines leitenden Kanals.

In einer zweiten, nicht ausschliesslich druckkontaktierten Ausführungsform sind zwischen den Hauptelektroden 5,6 und den metallischen Kontaktflächen zwecks stoffschlüssiger Verbindung Lotschichten vorgesehen. Die Lotschicht kann beispielsweise eine erste Hauptelektrode 5,6 und die zusätzliche, erfindungsgemässe Schicht 7 die gegenüberliegende Hauptelektrode 6,5 kontaktieren. Weiter kann die Lotschicht auch direkt die erfindungsgemässe Schicht 7 kontaktieren, wobei die Gegenseite wahlweise druckkontaktiert oder gelötet ist. Sehr vorteilhaft ist eine weitere Ausführungsform, bei welcher die Lot- und die erfindungsgemässe Schicht 7 identisch sind. Das Lot enthält in diesem Fall mindestens eine Komponente, die mit Silizium zusammen ein Eutektikum bildet.

Für einen Si-Halbleiterchip bietet sich als Eutektikumspartner Ag an. Der Schmelzpunkt einer AgSi Legierung mit 11 at% Ag (Eutektischer Punkt) liegt bei 835°C und damit deutlich tiefer als derjenige von reinem Si. Experimente mit Ag haben zu reproduzierbar stabilen Kurzschlüssen geführt mit Stromtragfähigkeiten bis über 1500 A Nennstrom pro Einzelchip (Chipfläche 12x12mm) und über eine Dauer von mehr als 1000h. Aber auch Au, Cu, Mg oder Al sind denkbar, Al wegen seiner Oxidationsanfälligkeit jedoch vorzugsweise in hermetisch abgeschlossenen Gehäusen. Im Weiteren sind selbstverständlich auch andere Materialien möglich, insbesondere falls ein anderes Halbleitermaterial gewählt wird.

Der Eutektikumspartner muss nicht in reiner Form vorliegen, sondern kann selber Teil einer Verbindung oder Legierung sein, beispielsweise in Form eines silberhaltigen Lotes. Vorteilhafterweise liegt der Schmelzpunkt einer solchen Verbindung unterhalb demjenigen des Eutektikums. Der Eutektikumspartner sollte mindestens 10 Volumenprozente der Verbindung oder Legierung ausmachen.

Bei allen vorgängig geschilderten Ausführungsformen passiert im Schadensfall folgendes: Als primäres Schadensereignis tritt ein Kurzschluss auf in einem Einzelchip, worauf der gesamte Nennstrom durch diesen Chip fliesst. Die Sandwichstruktur aus Halbleiterchip 4, Elektroden 5,6 und der erfindungsgemässen Schicht 7 erwärmt sich, bis ab Erreichen des Eutektischen Punktes eine siliziumhaltige Schmelze gebildet wird. Falls die erfindungsgemässe Schicht eine ausreichende Dicke aufweist, kann sich ausgehend von der Kontaktfläche ein leitender Kanal aus Schmelze durch den ganzen Chip ausbilden. Dieser trägt den Strom und verhindert, dass sich die Sandwichstruktur bis zum Schmelzpunkt von reinem Si aufwärmt.

Auf die Art und interne Struktur der Halbleiterchips selbst ist in den bisherigen Erläuterungen nicht eingegangen worden. Sofern das Modul insgesamt ein IGBT Modul darstellt, ist die interne Struktur entsprechend diejenige eines IGBT oder einer Diode, die Erfindung kann aber auch auf andere kleinflächige Halbleiterbauelemente angewendet werden.

### BEZUGSZEICHENLISTE

- 1: Gehäuse
- 2: Substrat
- 3: Kontaktstempel .
- 4: Halbleiterchip
- 5, 6: Hauptelektroden
- 7: Schicht

## Patentansprüche

1. Leistungshalbleitermodul, umfassend in einem Gehäuse (1) ein Substrat (2), mindestens zwei IGBT Halbleiterchips (4) mit je zwei Hauptelektroden (5,6), und für jeden Halbleiterchip (4) einen Kontaktstempel (3), wobei
a) die jeweils erste Hauptelektrode (5) mit dem Substrat (2) und die jeweils zweite Hauptelektrode (6) mit dem Kontaktstempel (3) in elektrischem Kontakt steht,
b) zwischen einer Hauptelektrode (5,6) und dem Substrat (2) oder dem Kontaktstempel (3) eine elektrisch leitende Schicht (7) vorgesehen ist,
c) die elektrisch leitende Schicht (7) ein Material enthält, welches zusammen mit dem Halbleitermaterial eine Verbindung oder Legierung bilden kann, deren Schmelzpunkt unterhalb desjenigen des Halbleitermaterials liegt, und
d) das Gehäuse die Halbleiterchips nicht luftdicht umgibt,
**dadurch gekennzeichnet, dass**
die Dicke der elektrisch leitenden Schicht (7) mindestens gleich der halben Dicke des Halbleiterchips (4) ist.

2. Leistungshalbleitermodul nach Anspruch 1, **dadurch gekennzeichnet, dass** das Halbleitermaterial Si ist und das Material der Schicht (7) Al, Au, Ag oder Mg oder eine Verbindung dieser Elemente enthält.

3. Leistungshalbleitermodul nach einem der vorangehenden Ansprüche, **dadurch gekennzeichnet, dass** die Schicht (7) eine Paste ist.

4. Leistungshalbleitermodul nach Anspruch 1 oder 2, **dadurch gekennzeichnet, dass** die Schicht (7) eine Lotschicht ist.

5. Leistungshalbleitermodul nach Anspruch 3 oder 4, **dadurch gekennzeichnet, dass** der Anteil der mit dem Halbleitermaterial ein Eutektikum bildenden Elemente in der Schicht (7) mindestens 10 Volumenprozent beträgt.

## Claims

1. Power semiconductor module, comprising a substrate (2), at least two IGBT semiconductor chips (4), each having two main electrodes (5,6), and a contact piston (3) for each semiconductor chip (4) in a case (1), with
a) the respectively first main electrode (5) making electrical contact with the substrate (2), and the respectively second main electrode (6) making electrical contact with the contact piston (3),
b) an electrically conductive layer (7) being provided between one main electrode (5,6) and the substrate (2) or the contact piston (3),
c) the electrically conductive layer (7) containing a material which, together with the semiconductor material, can form a compound or an alloy whose melting point is below that of the semiconductor material, and
d) with the case not surrounding the semiconductor chips in an airtight manner,
**characterized in that** the thickness of the electrically conductive layer (7) is equal to at least half the thickness of the semiconductor chip (4).

2. Power semiconductor module according to Claim 1, **characterized in that** the semiconductor material is Si, and the material of the layer (7) contains Al, Au, Ag or Mg or a compound of these elements.

3. Power semiconductor module according to either of the preceding claims, **characterized in that** the layer (7) is a paste.

4. Power semiconductor module according to Claim 1 or 2, **characterized in that** the layer (7) is a solder layer.

5. Power semiconductor module according to Claim 3 or 4, **characterized in that** the proportion of the elements which form a eutectic mixture with the semiconductor material in the layer (7) is at least 10 per cent by volume.

## Revendications

1. Module semi-conducteur de puissance, comprenant dans un boîtier (1) un substrat (2), au moins deux puces à semi-conducteur (4) de transistor bipolaire à grille isolée (IGBT) avec chacune deux électrodes principales (5, 6), et un plot de contact (3) pour chaque puce à semi-conducteur (4), dans lequel
a) chaque première électrode principale (5) est en contact électrique avec le substrat (2) et chaque deuxième électrode principale (6) est en contact électrique avec le plot de contact (3),
b) il est prévu une couche électriquement conductrice (7) entre une électrode principale (5, 6) et le substrat (2) ou le plot de contact (3),
c) la couche électriquement conductrice (7) contient une matière qui peut former avec le matériau semi-conducteur un composé ou un alliage, dont le point de fusion est situé en dessous de celui du matériau semi-conducteur, et
d) le boîtier entoure d'une façon qui n'est pas étanche à l'air les puces à semi-conducteur,
**caractérisé en ce que** l'épaisseur de la couche électriquement conductrice (7) est au moins égale à la moitié de l'épaisseur de la puce à semi-conducteur (4).

2. Module semi-conducteur de puissance selon la revendication 1, **caractérisé en ce que** le matériau semi-conducteur est le Si et la matière de la couche (7) contient Al, Au, Ag ou Mg ou un composé de ces éléments.

3. Module semi-conducteur de puissance selon l'une quelconque des revendications précédentes, **caractérisé en ce que** la couche (7) est une pâte.

4. Module semi-conducteur de puissance selon la revendication 1 ou 2, **caractérisé en ce que** la couche (7) est une couche brasée.

5. Module semi-conducteur de puissance selon la revendication 3 ou 4, **caractérisé en ce que** la proportion des éléments formant un eutectique avec le matériau semi-conducteur dans la couche (7) vaut au moins 10 pour cent en volume.
